(19) Europäisches Patentamt
European Patent Office
Office européen des brevets

(11) Veröffentlichungsnummer : **0 236 261 B1**

# (12) EUROPÄISCHE PATENTSCHRIFT

(45) Veröffentlichungstag der Patentschrift : **08.04.92 Patentblatt 92/15**

(51) Int. Cl.$^5$ : **C08G 2/14,** C08G 2/20, G03F 7/004

(21) Anmeldenummer : **87810014.8**

(22) Anmeldetag : **12.01.87**

## (54) Neue organometallhaltige Polymere.

(30) Priorität : **16.01.86 CH 147/86**

(43) Veröffentlichungstag der Anmeldung : **09.09.87 Patentblatt 87/37**

(45) Bekanntmachung des Hinweises auf die Patenterteilung : **08.04.92 Patentblatt 92/15**

(84) Benannte Vertragsstaaten : **AT CH DE FR GB IT LI NL SE**

(56) Entgegenhaltungen :
**EP-A- 0 126 214**
**US-A- 3 940 507**

(56) Entgegenhaltungen :
**Macromolecules, Band 2, Nr. 1, Jänner/Februar 1969, American Chemical Society CH.ASO; S. Tagami; "Polymerization of Aromatic Aldehydes. III. The Cyclopolymerization of Phthalaldehyde and the Structure of the Polymer" Seiten 414-419**
**Polymer Engineering and Science, Band 23, Nr. 18, Dezember 1983, Society of Plastics Engineers H. ITO; C. Grant Wilson; "Chemical Amplification in the Design of Dry Developing Resist Materials" Seiten 1012-1018**

(73) Patentinhaber : **CIBA-GEIGY AG**
**Klybeckstrasse 141**
**CH-4002 Basel (CH)**

(72) Erfinder : **Steinmann, Alfred, Dr.**
**Chemin du Verger 12**
**CH-1752 Villars-sur-Glâne (CH)**

EP 0 236 261 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft neue organometallhaltige Polyphthalaldehyde; strahlungssensitive, trocken entwickelbare, Sauerstoffplasma resistente Zusammensetzungen enthaltend diese Verbindungen; sowie deren Verwendung zur Erzeugung von strukturierten Positiv-Bildern.

Unter selbst- oder trockenentwickelbaren Zusammensetzungen (Resists) versteht man eine Klasse von Verbindungen, welche nach Bestrahlung in flüchtige Teilchen zerfällt, oder welche nach der Bestrahlung mit einem Plasma strukturiert werden können, ohne dass eine Nass-Entwicklung zur Bilderzeugung notwendig ist. Verschiedene Materialien wurden für diesen Zweck vorgeschlagen, so z.B. Polymethylmethacrylat, Polyethylenterephtalat, Nitrocellulose oder Polyisopren (s. beispielsweise H. Franke, Appl. Phys. Lett. 45(1), 110 ff (1984). Bei der Verwendung solcher Materialien treten häufig verschiedene Nachteile auf, wie niedrige Empfindlichkeit, mangelhafte Stabilität, Bildung von nichtflüchtigen Rückständen, mangelnde Resistenz gegen Sauerstoffplasma, oder mangelnde Auflösung.

In der EP-A 126,214 wird ein System beschrieben, das sich durch seine gute Empfindlichkeit auszeichnet. Die selbstentwickelbare Zusammensetzung besteht aus Polyphthalaldehyd, welches mittels photochemisch erzeugten Säuren katalytisch depolymerisiert wird und die so erzeugten Phthalaldehyd-Monomeren verdampft werden.

Der Nachteil dieses Systems liegt in der grossen Initiatormenge von 10 Gew.%, die benötigt wird, um eine Empfindlichkeit von 1,5-5 $mJ/cm^2$ zu erzielen. Hohe Säurekatalysatorenkonzentrationen sind deshalb unerwünscht, weil Rückstände selbst nach der thermischen Selbstentwicklung im System verbleiben und damit eine beachtliche Kontaminationsgefahr darstellen. Wird in dem System der EP-A 126,214 die Konzentration des Initiators reduziert, steigen die benötigten Belichtungsdosen um ein Vielfaches. Ausserdem ist dieses System instabil unter Plasmaätzbedingungen (z.B. $O_2$-Plasma), wie sie üblicherweise angewendet werden, um Strukturen in ein darunterliegendes, organisches Planarisierharz zu transferieren.

Ein weiteres selbstentwickelbares Polyaldehyd-System wird in der EP-A 109,617 beschrieben. Da aliphatische Polyaldehyde in organischen Lösungsmitteln praktisch unlöslich sind, und zudem eine tiefe Glasumwandlungstemperatur $T_g$ haben, eignen sie sich nicht als Materialien zur Bilderzeugung. Zur Erhöhung der Löslichkeit werden daher siliziumhaltige Substituenten eingeführt. Allerdings sind die Löslichkeiten immer noch unbefriedigend, der $T_g$ noch tiefer und für die Bilderzeugung ist hochenergetische Strahlung notwendig.

Es wurde nun eine Klasse organometallhaltiger endverkappter Polyphthalaldehyde gefunden, welche sich durch überraschend hohe Empfindlichkeit auszeichnen. Die benötigten Mengen Initiatorzusätze bzw. die Bestrahlungsdosen sind verglichen mit herkömmlichen Systemen äusserst gering. Damit verbunden ist auch der Anteil nichtflüchtiger Rückstände minimal. Die Zusammensetzungen besitzen sehr gute Löslichkeits- und Filmbildungseigenschaften, sowie eine gute Temperaturstabilität und Sauerstoffplasmaresistenz.

Die Erfindung betrifft organometallhaltige endverkappte Polyphthalaldehyde mit der wiederkehrenden Einheit der Formel I

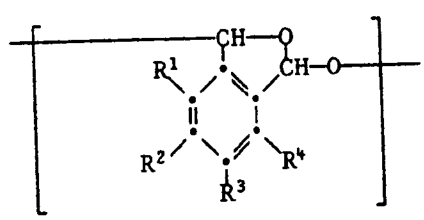

(I)

worin $R^1$, $R^2$, $R^3$ und $R^4$ unabhängig voneinander Wasserstoff, Halogen, Nitril, Nitro, Carboxyl, Hydroxyl, $C_1$-$C_4$-Alkoxy, $C_1$-$C_4$-Alkylthio oder Alkoxycarbonyl mit 1-4 C-Atomen im Alkoxyteil bedeuten und mindestens einer der Reste $R^1$, $R^2$, $R^3$ und $R^4$ eine Gruppe $-Q(R^5)_3$ oder $-Q(R^6)_3$ ist, wobei Q für Si, Sn, Ge, $CH_2$-Si oder O-Si steht, $R^5$ $C_1$-$C_{12}$-Alkyl ist und $R^6$ $C_6$-$C_{10}$-Aryl bedeutet.

Als $C_1$-$C_4$-Alkoxy sind die Reste Methoxy, Ethoxy, n-Propoxy oder n-Butoxy, bevorzugt Methoxy, zu erwähnen.

Sind $R^1$-$R^4$ Alkylthio, so sind Methylthio, Ethylthio, n-Propylthio oder n-Butylthio, insbesondere Methylthio zu erwähnen.

Als Alkoxycarbonyl handelt es sich z.B. um Methoxycarbonyl, Ethoxycarbonyl, n-Propoxycarbonyl oder n-Butoxycarbonyl.

Mindestens einer, bevorzugt einer oder zwei und insbesondere zwei der Reste $R^1$-$R^4$ bedeuten eine Gruppe $-Q(R^5)_3$ oder $-Q(R^6)_3$. Bevorzugt sind dabei siliziumhaltige Reste.

$R^5$ bedeutet $C_1$-$C_{12}$-, bevorzugt $C_1$-$C_4$-Alkyl und ist insbesondere Methyl oder Ethyl. Im übrigen kann es

sich um Isopropyl, n-Propyl, n-Butyl, n-Hexyl, n-Octyl, n-Decyl oder n-Dodecyl handeln.

$R^6$ ist als $C_6$-$C_{10}$-Aryl, insbesondere Phenyl oder Naphthyl.

In bevorzugten Verbindungen sind alle am Metall gebundenen Reste $R^5$ bzw. $R^6$ identisch.

Besonders hervorzuheben sind Verbindungen, in welchen $R^2$ und $R^3$ eine Gruppe -$Q(R^5)_3$ oder -$Si(R^6)_3$ sind, und die übrigen Reste $R^1$ und $R^4$ Wasserstoff bedeuten.

Zur Stabilisierung der Polymeren der Formel I, werden diese in bekannter Weise endverkappt. Als Verkappungsgruppen eignen sich Amine oder Acyle, wie sie z.B. von Hiroshi Ito und C.G. Willson, Polym. Eng. Sci. 23, 1012 ff (1983) beschrieben worden sind (s. auch Macromolecules 2(4), 414 (1969)).

Die Polymeren mit der wiederkehrenden Einheit der Formel I besitzen vorzugsweise ein mittleres Molekulargewicht von 10'000 bis 1'000'000 und insbesondere von 50'000-400'000.

Bei den neuen Polymeren der vorliegenden Erfindung handelt es sich vorzugsweise um Homopolymere. Als strahlungssensitive, trockenentwickelbare Zusammensetzung eignen sich aber auch Copolymere, so z.B Copolymere, welche aus zwei oder mehr Bausteinen der Formel I verschiedener Struktur aufgebaut sind oder um Copolymere, welche neben Struktureinheiten der Formel I bis zu 50 Mol%, bezogen auf das gesannte Copolymer, Struktureinheiten enthalten, welche sich von copolymerisierbaren Monomeren ableiten. Die vorliegende Erfindung betrifft worzugsweise Copolymere organometallhaltiger Phthalaldehyde enthaltend das wiederkehrende Strukturelement der Formel I

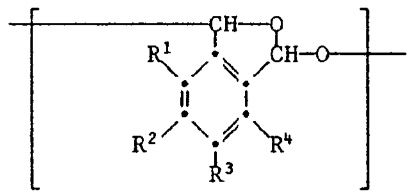

(I)

worin die Substituenten $R^1$ bis $R^4$ die oben angegebene Bedeutung haben, und bis zu 50 Mol-%, bezogen auf das gesamte Copolymer, mindestens eines der Struktvrelemente II, III oder IV

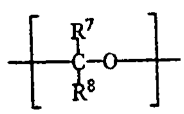

(II)

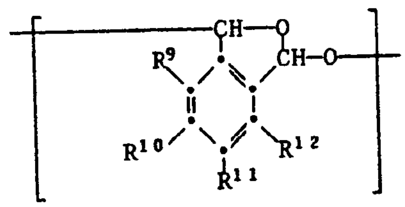

(III),

oder

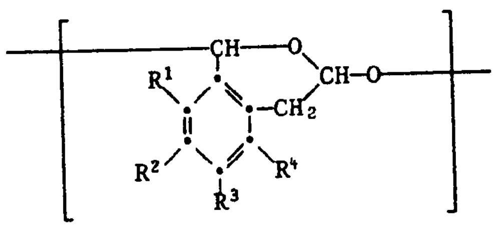

(IV)

worin $R^1$, $R^2$, $R^3$ und $R^4$ die oben angegebene Bedeutung haben, und $R^7$ und $R^8$ unabhängig voneinander Wasserstoff, $C_1$-$C_4$-Alkyl, Phenyl, oder durch eine Gruppe -$Q(R^5)_3$ oder -$Si(R^6)_3$ substituiertes $C_1$-$C_4$-Alkyl oder Phenyl ist, und Q, $R^5$ und $R^6$ die oben angegebene Bedeutung haben, und $R^9$, $R^{10}$, $R^{11}$ und $R^{12}$ unabhängig voneinander Wasserstoff, Halogen, Nitril, Nitro, Carboxyl, Hydroxyl, $C_1$-$C_4$-Alkyl, $C_1$-$C_4$-Alkoxy, $C_1$-$C_4$-Alkylthio oder Alkoxycarbonyl mit 1-4 C-Atomen im Alkoxyteil bedeuten, wobei Q, $R^5$ und $R^6$ die oben angegebene Bedeutung haben.

Sind $R^7$ und $R^8$ $C_1$-$C_4$-Alkyl, so handelt es sich beispielsweise um Methyl, Ethyl, Isopropyl, n-Propyl oder n-Butyl, bevorzugt um Methyl. Diese Alkylgruppen enthalten falls substituiert, vorzugsweise eine Gruppe -$Q(R^5)_3$ oder -$Si(R^6)_3$. Zur Bedeutung von Q, $R^5$ und $R^6$ verweisen wir auf die Beschreibung oben.

Als substituiertes Phenyl für $R^7$ und $R^8$ kommt Phenyl in Frage, welches durch zwei und vorzugsweise durch eine Gruppe -$Q(R^5)_3$ oder -$Si(R^6)_3$ substituiert ist. Zur Bedeutung von Q, $R^5$ und $R^6$ verweisen wir erneut auf die Beschreibung oben.

Im Rahmen der angegebenen Bedeutungen, gilt für die Reste $R^9$ $R^{10}$ $R^{11}$ und $R^{12}$ die im Zusammenhang

mit der Formel I angegebene Erklärung.

Typische Vertreter von Monomeren, von welchen sich die Strukturelemente der Formeln II, III oder IV ableiten, sind:

$OCH\text{-}CH_2CH_2\text{-}Si(CH_3)_3$, $OCH\text{-}C_6H_4\text{-}(p)Si(CH_3)_3$, Phthalaldehyd, oder o-Formylphenylacetaldehyd.

Besonders geeignet sind Monomere, von welchen sich Strukturelemente der Formel III ableiten.

Die Herstellung der erfindungsgemässen Homo- und Copolymere erfolgt auf an sich bekannte Weise durch Polymerisation eines Phthalaldehyds der Formel V

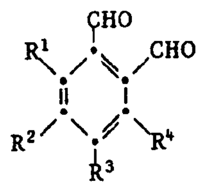

(V)

beiniedriger Temperatur in Gegenwart verschiedener Katalysatoren. Ueblicherweise wird eine solche Polymerisation in einem Lösungsmittel, wie Methylenchlorid, Toluol oder Tetrahydrofuran durchgeführt. Als Katalysatoren eignen sich kationische, wie Bortrifluorid-etherat, Triphenylmethyltetrafluoroborat, Zinntetrachlorid, u.a., ferner anionische, wie Lithium-t-butyrat, Natriumnaphthalid, Butyllithium oder Phenylmagnesiumbromi u.a., sowie KoordinationsKatalysatoren, wie Triethylalurinium/Titantetrachlorid, Triethylaluminium/Vanadiumtetrachlorid, Triethylaluminium/Trichlorovanadat oder Triethylaluminium/Cobaltdichlorid.

Ausserdem kann die Polymerisation auch durch Röntgenstrahlen initiiert werden.

Die Reaktion dauert etwa 1 bis 10 Stunden und das so erhaltene Polymer kann in bekannter Weise endverkappt werden. Als Verkappungsmittel eignet sich z.B. Amine für die kationische Reaktionsführung oder Säurechloride oder Anhydride für die anionische Reaktionsführung.

Die Herstellung der erfindungsgemässen Polymeren erfolgt z.B. nach den im US 3,940,507 beschriebenen Verfahren oder gemäss C. Aso und S. Tagami, Macromolecules 2, 414 ff (1969).

Die zur vorliegenden Erfindung gehörenden Copolymeren können grundsätzlich nach dem gleichen Prinzip hergestellt werden, wobei ein Phthalaldehyd der Formel V mit mindestens einem Monomeren der Formeln II*, III* oder IV*

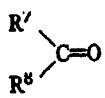

(II*),

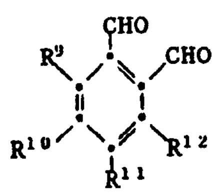

(III*),

oder

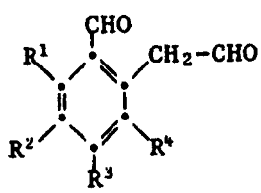

(IV*),

worin die Substituenten die oben angegebene Bedeutung haben, auf an sich bekannte Weise in den oben für die Homopolymerisation angegebenen Verhältnissen copolymerisiert werden.

Die Monomeren der Formeln II*, III* und IV* sind bekannte Verbindungen und können, falls aie teilweise noch neu sind, in Analogie zu bekannten hergestellt werden.

Die Monomeren der Formel V sind neu und können in an sich bekannter Weise aus den entsprechenden Halogeniden der formeln VI oder VII

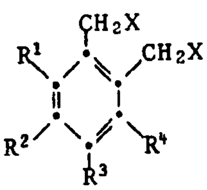 (VI) oder 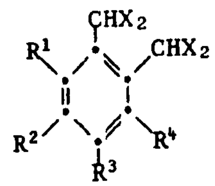 (VII)

worin $R^1$, $R^2$,, $R^3$ und $R^4$ die in der Formel I angegebene Bedeutung haben und X jeweils Br, Cl oder I bedeutet, hergestellt werden.

Die Ueberführung der Verbindungen der Formel VI in die Phthalaldehyde der Formel V erfolgt oxidativ zum Beispiel mittels Dimethylsulfoxid oder Hexamethylentetramin. Verfahren dieser Art sind detailliert beschrieben, z.B. in J.Chem.Soc. 692 (1940); J.Org.Chem. 24, 1792 ff (1959) oder J.Am.Chem.Soc. 81, 4113 ff (1959).

Zur Herstellung der Phthalaldehyde der Formel V aus den entsprechenden Tetrahalogenverbindungen der Formel VII durch Hydrolyse mit einem Metall- oder Ammoniumsalz einer organischen Säure in wässrigem Medium in Gegenwart eines Phasentransferkatalysators und einer anorganischen Base kann auf die Methode der EP-A 03 230 verwiesen werden. Die Oxidation mittels Kaliumoxalat ist ausserdem in "Organic Synthesis", Coll.Vol. IV, 807 ff (1963) beschrieben.

Die Verbindungen der Formeln VI und VII können analog dem in J.Chem.Soc., 79, Seite 6540 ff (1957) offenbarten Verfahren hergestellt werden, indem man Verbindungen der Formel VIII

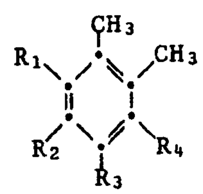 (VIII)

worin $R_1$, $R_2$, $R_3$ und $R_4$ die gleiche Bedeutung wie in Formel I haben, mit N-Bromsuccinimid in Gegenwart eines Katalysators, vorzugsweise eines Peroxids, wie Benzoylperoxid, zu Verbindungen der Formel VI oder VII bromiert.

Die Verbindungen der Formel VIII sind bekannt und können wie beispielsweise in J.Chem.Soc. 3640 (1959) und J.Organomet.chem. 84(2) (1975) 165-175, J.Organomet.chem. 289(2-3) (1985) 331-9 beschrieben oder in analoger Weise hergestellt werden.

Die erfindungsgemässen Polymeren eignen sich vortrefflich als strahlungssensitives, trocken entwickelbares Aufzeichnungsmaterial. Wie bereits erwähnt, lassen sich die Verbindungen mit der wiederkehrenden Struktureinheit (I) zur Herstellung von positiv arbeitenden Photoresistsystemen verwenden.

Die Erfindung betrifft daher auch strahlungssensitive, trocken entwickelbare Zusammensetzungen enthaltend ein organometallhaltiges, endverkapptes Polyphthalaldehyd mit der wiederkehrenden Einheit der Formel I; sowie Copolymere, welche durch Copolymerisation von Phthalaldehyden der Formel V mit bis zu 50 Mol-% von Monomeren der Formel II, III oder IV erhalten werden und eine unter Einwirkung von aktinischer Strahlung eine Säure abspaltende Verbindung.

Als strahlungsempfindliche Komponenten, die bei Lichteinwirkung Säure bilden bzw. abspalten, sind eine grosse Anzahl von Verbindungen bekannt. Dazu zählen beispielsweise Diazoniumsalze, wie sie in der Diazotypie verwendet werden, o-Chinondiazide, wie sie in bekannten positiv arbeitenden Kopiermassen verwendet werden, oder auch Halogenverbindungen, die bei Bestrahlung Halogenwasserstoffsäure bilden. Verbindungen dieses Typs sind beispielsweise in den US-PS 3,515,552, 3,536,489 oder 3,779,778, sowie in den DE-OS 2,718,259, 2,243,621 oder 2,610,842 beschrieben.

Als strahlungsempfindliche Komponenten der erfindungsgemässen Zusammensetzungen eignen sich aber auch kationische Photoinitiatoren aus der Gruppe der Iodonium- oder Sulfoniumsalze. Solche Verbindungen sind beispielsweise in "UV-Curing, Science and Technology" (Editor: S.P. Pappas, Technology Marketing Corp., 642 Westover Road, Stanford, Conneticut, USA) beschrieben.

Insbesondere sind auch Diaryliodosyl-Salze einsetzbar. Solche Verbindungen sind beispielsweise in der EP-A 106,797 beschrieben.

Ferner können Sulfoxoniumsalze als strahlungsempfindliche Verbindungen verwendet werden. Solche Salze sind beispielsweise in der EP-PS 35,969 oder in den EP-A 44,274 bzw. 54,509 beschrieben. Insbesondere zu erwähnen sind aliphatische Sulfoxoniumsalze, die im tiefen UV-Bereich absorbieren.

Insbesondere lassen sich auch Verbindungen einsetzen, die bei Bestrahlung mit aktinischem Licht Sulfonsäuren freisetzen. Solche Verbindungen sind an sich bekannt und beispielsweise in der GB-A 2,120,263, den EP-A 84,515, 37,152 oder 58,638 bzw. in den US-PS 4,258,121 oder 4,371,605 beschrieben.

Werden als strahlungsempfindliche säureabspaltende Komponenten Salze eingesetzt, so sind diese vorzugsweise in organischen Lösungsmitteln löslich. Besonders bevorzugt handelt es sich bei diesen Salzen um Abscheidungsprodukte mit komplexen Säuren, beispielsweise von Borfluorwasserstoffsäure oder Hexafluorphosphorsäure.

Die Menge der strahlungsempfindlichen Komponente der erfindungsgemässen Zusammensetzungen kann je nach Natur und Zusammensetzung des strahlungsempfindlichen Gemisches in weiten Grenzen variiert werden. Günstige Ergebnisse werden erzielt, wenn etwa 0,05 bis 5 Gew.-% an Komponente, bezogen auf das Polyphthalaldehyd, eingesetzt werden. Vorzugsweise setzt man 0,2 bis 1 Gew.-% Säurespender, bezogen auf das Polyphthalaldehyd ein. Da die strahlungsempfindliche Komponente (Initiator) nach der Trockenentwicklung im System zurückbleibt, wird vorzugsweise möglichst wenig dieser Substanzen eingesetzt, um negative Beeinflussungen in nachfolgenden Prozesschritten zu verhindern. Bei der hohen Empfindlichkeit des vorliegenden Systems ist dies möglich, was als grosser Vorteil gegenüber dem Stand der Technik zu werten ist und nicht erwartet werden konnte.

Die erfindungsgemässe Zusammensetzung kann weitere übliche Zusatzstoffe enthalten, wie z.B. Stabilisatoren, Sensibilisatoren, gebräuchliche Polymere, wie Polystyrol oder Polymethylmethacrylat, Pigmente, Farbstoffe, Füllstoffe, Haftvermittler, Verlaufmittel, Netzmittel und Weichmacher. Ferner können die Zusammensetzungen zur Applikation in geeigneten Lösungsmitteln gelöst werden.

Die erfindungsgemässen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie von Metallen, wie Al, Cu, Ni, Fe, Zn, Mg oder Co, und von Halbleitermaterialien wie Si, $Si_3N_4$, $SiO_2$, GaAs, Ge, etc. bei denen durch bildmässiges Belichten eine Abbildung aufgebracht werden soll. Ein weiterer Gegenstand vorliegender Erfindung sind die beschichteten Substrate.

Die Herstellung der beschichteten Substrate kann z.B. erfolgen, indem man eine Lösung oder Suspension der Zusammensetzung herstellt. Als Lösungsmittel eignen sich alle nicht allzu polaren und nicht zu niedrig siedenden Lösungsmittel, z.B. Ether, Ketone oder Aromaten, wie Tetrahydrofuran, Dioxan, Cyclohexanon, Benzol oder Toluol. Bevorzugt sind 1-20%-ige Polymerlösungen. Die Lösung wird mittels bekannten Beschichtungsverfahren auf ein Substrat gleichförmig aufgebracht, z.B. durch Schleudern, Tauchen, Rakelbeschichtung, Vorhanggiessverfahren, Aufpinseln, Sprühen und Reverse Rollbeschichtung. Es ist auch möglich, die lichtempfindliche Schicht auf einen temporären, flexiblen Träger zu bringen, und dann durch Schichtübertragung via Lamination das endgültige Substrat, z.B. eine Silizium-Wafer, zu beschichten.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in sehr dünnen Schichten eingesetzt werden können, und sich durch eine hervorragende Auflösung auszeichnen. Sie eignen sich bei entsprechend gewählter Strahlungsquelle und strahlungsempfindlicher Komponente für ein breites Spektrum von Anwendungsgebieten, wo die Erzeugung von strukturierten Bildern erwünscht ist. Besonders vorteilhaft ist ihr Einsatz jedoch in der Submikronlithographie sowie der Mehrschichtenlithographie, wo heute die Anforderungen der Mikroelektronik an ein Resistsystem besonders hoch sind. Daher sind bevorzugte Filmschichtdicken 0,3-2,0 $\mu$m.

Nach dem Beschichten wird das Lösungsmittel üblicherweise durch Trocknen entfernt und es resultiert eine amorphe Schicht des Resists auf dem Träger.

Zwischen Träger und Resist kann, falls erwünscht, eine weitere Schicht aufgetragen werden. Dieses sogenannte Planarisierharz ermöglicht das Auftragen besonders dünner Resistschichten. Grundsätzlich eignen sich alle organischen Polymere und Oligomere, welche als Polymerlösung auf einen Träger aufgebracht werden können. Beispiele solcher sind Polyimide, Polyamidsäuren, Polymethylmethacrylat, Novolake oder auch andere Resistsysteme.

Die strahlungssensitive Schicht wird in üblicher Weise bildmässig einer geeigneten Strahlung ausgesetzt. Die belichteten Stellen dieser Schicht depolymerisieren und die entstandenen Monomere verdampfen, wodurch die darunterliegende Schicht, bzw. der Träger freigelegt wird. Es ist ein Vorteil des erfindungsgemässen Systems, dass zu dieser Freilegung kein Lösungsmittel verwendet werden muss und die saubere und rückstandsfreie Selbstentwicklung sehr scharfe Positivbilder liefert. Je nach Art des entstehenden Monomers kann die Freilegung stark beschleunigt werden, durch Erwärmen und/oder Anlegen von Vakuum.

Bevorzugt sind Erwärmungen zwischen 20 und 120°C während 1-60 Minuten.

Belichtungen mit aktinischer Strahlung werden durch eine Quartzmaske, die ein vorbestimmtes Muster enthält oder durch einen Laserstrahl, der beispielsweise computergesteuert über die Oberfläche des beschichteten Substrates bewegt wird, durchgeführt.

Bevorzugt werden zur Belichtung UV-Strahlen (200-450 nm), Elektronenstrahlen, Röntgenstrahlen oder Ionenstrahlen verwendet.

Was das erfindungsgemässe System gegenüber dem Stand der Technik ausserdem auszeichnet, ist dessen unerwartet hohe Empfindlichkeit bei gleicher Schichtdicke. Obwohl bedeutend geringere Mengen an strahlungsempfindlichem Initiator nötig sind, ist die benötigte Strahlungsintensität bedeutend geringer. So kommt man mit beispielsweise 0,1-0,3 mJ/cm² aus, um zum gewünschten Resultat zu kommen.

Das erfindungsgemässe Aufzeichnungsmaterial ist ferner als Plasmaätzresist geeignet. So sind die unbelichteten Stellen des strukturierten Bildes z.B. gegen Sauerstoffplasma-Aetzbedingungen resistent.

Beispiel 1: Herstellung von 4-Trimethylsilyl-α,α,α',α'-tetrabromo-xylol

In einem mit Kühler und Rührer ausgerüsteten 1,5-Liter Sulfierkolben werden unter Stickstoff 100 g (562 mmol) 4-Trimethylsilyl-o-xylol, 400 g (2250 mmol) N-Bromsuccinimid, 1 g Dibenzoylperoxid und 750 ml Tetrachlorkohlenstoff vorgelegt. Man erwärmt das Reaktionsgemisch auf Siedehitze, bis die Reaktion exotherm wird. Das Heizbad wird jetzt entfernt, bis das spontane Sieden abklingt. Danach wird noch etwa eine Stunde bei Siedehitze gerührt. Die gaschromatographische Analyse zeigt, dass kein 4-Trimethylsilyl-o-xylol mehr vorhanden ist. Das Gemisch wird auf 0°C gekühlt und das Succinimid abgetrennt. Das Filtrat wird nun mit 200 ml kalter 5%-iger Natronlauge zweimal extrahiert und einmal mit Wasser gewaschen. Die $CCl_4$-Phase wird mit Magnesiumsulfat getrocknet und das $CCl_4$ am Rotationsverdampfer vertrieben.

Man erhält 250 g eines Festkörpers (90 % der Theorie), der bei 94°C schmilzt. Durch zweimaliges Umtiristallisieren in wenig n-Hexan erhält man weisse Kristalle mit einem Schmelzpunkt von 97°C (Siedepunkt der Verbindung: 138°C/0,13 mbar).

Elementaranalyse:

| | berechnet | gefunden |
|---|---|---|
| C [%] | 26,75 | 26,75 |
| H [%] | 2,86 | 2,87 |
| Br [%] | 64,71 | 64,54 |

$^1$H-NMR-Spektrum (Aceton-$d_6$):

| | | |
|---|---|---|
| $CH_3$-Si | 9H(s) : | 0.4 ppm |
| $Br_2CH$ | 2H(s) : | 7.95 ppm und 7.5 ppm |
| H-aromat. | 3H(m) : | 7.6-7.85 ppm |

Beispiel 2:

Herstellung von 4-Trimethylsilyl-o-phthaldialdehyd 175 g (355 mMol) 4-Trimethyl-α,α,α',α'-tetrabrom-o-xylol, 119 g Natriumformiat, 72 g Calciumcarbonat, 26 g Tetrabutylammoniumbromid und 150 ml Wasser werden in einem 750 ml Sulfierkolben mit Rührer vorgelegt. Unter Stickstoff wird das Gemisch auf etwa 100°C erwärmt, wobei das 4-Trimethyt-α,α,α',α'-tetrabrom-o-xylol aufschmilzt. Dann wird kräftig gerührt, so dass die verschiedenen Phasen gut vermischt werden. Nach etwa 12 Stunden wird auf 0°C abgekühlt und die Mischung mit 400 ml Diethylether extrahiert. Die getrocknete organische Phase wird eingeengt. Der Rückstand wird anschliessend über eine Kieselgel-Kolonne mit Toluol chromatographiert. Nach dem Einengen der Toluolfraktionen erhält man 54 g (61 % der Theorie) des reinen 4-Trimethylsilyl-o-phthaldialdehyds.
Dieser wird in etwa dem gleichen Volumen n-Hexan gelöst. Im Kühlschrank bilden sich gelbliche Kristalle, die einen Schmelzpunkt von 38°C haben. Siedepunkt der Verbindung: 98°C/0,13 mbar.

Elementaranalyse:

| | berechnet | gefunden |
|---|---|---|
| C [%] | 64,04 | 63,94 |
| H [%] | 6,84 | 6,96 |
| Si [%] | 13,62 | 13,04 |

$^1$H-NMR-Spektrum (Aceton-$d_6$):

| | |
|---|---|
| $CH_3$-Si (9H): | 0.36 ppm (s) |
| H-aromat. (3H): | 8.0 ppm (m) |
| H-aromat. (1H): | 8.1 ppm (s) |
| CHO (2H): | 10.6 ppm (s) |

Beispiel 3: Herstellung von 4,5-Bis(trimethylsilyl)-α,α,α',α'-tetrabrom-o-xylol

In einem 1,5 l Sulfierkolben, der mit einem Rührer und einem Kühler versehen ist, werden unter Stickstoff 70 g (280 mmol) 4,5-Bis(trimethylsilyl)-o-xylol, 224 g (1260 mmol) N-Bromsuccinimid, 5 g Dibenzoylperoxid und 800 ml Tetrachlorkohlenstoff vorgelegt. Man erwärmt die Suspension bis zum selbständigen Sieden. Nach der Exothermie wird noch für etwa drei Stunden am Rückfluss gekocht. Die Suspension wird abgekühlt, vom Succinimid abgetrennt und das Filtrat zweimal mit 10%iger kalter Natronlauge gewaschen. Die getrocknete organische Phase wird vom Lösungsmittel befreit. der gewonnene Festkörper wird in n-Hexan umkristallisiert.
Man erhält 120 g (75 %) Festkörper, der bei 157°C schmilzt.

Elementaranalyse:

| | berechnet | gefunden |
|---|---|---|
| C [%] | 29,70 | 28,90 |
| H [%] | 3,92 | 4,02 |
| Br [%] | 56,46 | 56,38 |

$^1$H-NMR (Aceton-$d_6$):

| | |
|---|---|
| $CH_3$-Si (18H): | 0.44 ppm (s) |
| $Br_2CH$ (2H): | 7.65 ppm (s) |
| H-aromat. (2H): | 8.1 ppm (s) |

Beispiel 4: Herstellung von 4,5-Bis(trimethylsilyl)-o-phthaldialdehyd

85 g (150 mmol) 4,5-Bis(trimethylsilyl)-α,α,α',α'-tetrabrom-o-xylol, 71,5 g Natriumformiat, 35 g Calciumcarbonat, 113 g Tetrabutylammoniumbromid, 175 ml Wasser und 200 ml Toluol werden in einem 750 ml Sulfierkolben eingebracht und unter Stickstoff wird bei 120°C stark gerührt. Nach 2 Tagen wird auf Raumtemperatur abgekühlt und mit Toluol verdünnt. Die organische Phase wird mit Wasser gewaschen und getrocknet. Das Lösungsmittel wird am Rotationsverdampfer entfernt und der Festkörper in n-Hexan bis zum konstanten Schmelzpunkt umkristallisiert.
Man erhält 17 g (40 %) einer gelblichen, kristallinen Substanz, die bei 103°C schmilzt.

Elementaranalyse:

| | berechnet | gefunden |
|---|---|---|
| C [%] | 60,38 | 59,90 |
| H [%] | 7,96 | 8,05 |

$^1$H-NMR (Aceton-$d_6$):

| | |
|---|---|
| $CH_3$-Si (18H): | 0.4 ppm (s) |
| H-aromat. (2H): | 8.3 ppm (s) |
| CHO (2H): | 10.5 ppm (s) |

Beispiel 5:

Polymerisation von 4-Trimethylsilyl-o-phthaldialdehyd Unter Stickstoff werden 24 g (116 mMol) 4-Trimethylsilyl-o-phthaldialdehyd und 100 ml trockenes Methylenchlorid vorgelegt, in flüssigem Stickstoff abgekühlt und 2 Mol-% $BF_3$·diethylether als Initiator zugesetzt. Danach wird die Lösung im Hochvakuum vom Sauerstoff befreit.

In einem Kältebad lässt man unter Stickstoff bei -78°C polymerisieren. Nach wenigen Stunden gibt man bei -78°C zur hochviskosen Lösung 2 ml -78°C kaltes Pyridin/Essigsäureanhydridgemisch (Verhältnis 1:1) hinzu. Man rührt noch 0,5 Stunden bei -78°C, erwärmt auf Raumtemperatur und giesst die Lösung in 1000 ml Methanol, wobei das Polymer sofort ausfällt. Dieses wird abgetrennt und getrocknet. Ausbeute: 23,5 g.

Zur Reinigung wird das Polymer nochmals in 300 ml Methylenchlorid gelöst, filtriert und erneut in 1000 ml Methanol ausgefällt. Das Polymer wird abgetrennt und bei Raumtemperatur am Hochvakuum getrocknet.

Ausbeute: 19.3 g (80 % der Theorie).

Das Polymer hat einen Zersetzungspunkt von 156°C.

Gelpermeationschromatoraphische Messungen in Tetrahydrofuran zeigen
ein $\overline{M}_w$ von 290'000 und
ein $\overline{M}_n$ von 80'000.

Beispiel 6: Polymerisation von 4,5-Bis(trimethylsilyl)-o-phthaldialdehyd

4 g (14,4 mmol) 4,5-Bis(trimethylsilyl)-o-phthaldialdehyd werden in einer Ampulle mit 12 ml trockenem Methylenchlorid gelöst. Durch Gefrieren/Auftauen wird am Hochvakuum von Sauerstoff befreit. Ueber eine Spritze gibt man 2 Mol % (bezüglich Monomer) einer $BF_3$-Diethyletheratlösung in Methylenchlorid zur gefrorenen Lösung und lässt dann bei -78°C unter Stickstoff polymerisieren. Nach wenigen Stunden gibt man zur hochviskosen Lösung 1 ml Pyridin, das vorgekühlt war. Dann lässt man die Lösung auf Raumtemperatur erwärmen und fällt das Polymer in Methanol aus. Das weisse Pulver wird getrocknet, erneut in Methylenchlorid gelöst und nochmals in Methanol ausgefällt.

Das weisse Polymerpulver wird am Hochvakuum bei 50°C getrocknet. Man erhält 3,1 g (77 %) Polymer.

Das Polymer hat einen Zersetzungspunkt von 170°C. GPC-Messungen in THF zeigen ein $\overline{M}_w$ von 420'000 und ein $\overline{M}_n$ von 180'000.

| | | | |
|---|---|---|---|
| $^1H$-NMR ($CDCl_3$): | $CH_3$-Si | (18H): | 0.4 ppm (s) |
| | ar-H | (2H): | 8.2 ppm (s) |
| | 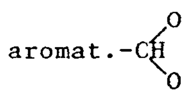 | (2H): | 10.6 ppm (s) |

Beispiel 7:

Zu einer 10%-igen Lösung des Polymers gemäss Beispiel 5 in Cyclohexanon werden 1 Gew.% Diphenyliodoniumhexafluoroarsenat, bezogen auf das Polymer, gegeben. Die filtrierte Lösung wird bei 2500 rpm durch Schleuderbeschichtung auf einen Silizium-Wafer gebracht. Der Polymerfilm wird während 25 min. bei 95°C getrocknet. Die Schichtdicke des amorphen films beträgt 0,9 µm.

Dieser Resistfilm wird bei 254 nm während 0,2 sec. durch eine Quarzmaske belichtet (Intensität der Hg-Xe-Lampe bei 254 nm : 1 mw/cm²). Das belichtete Material wird anschliessend während 4 min. auf 110°C erhitzt.

Dabei entstehen auffallend sauber aufgelöste Strukturen im Submikronbereich.

Beispiel 8:

Auf einen Silizium-Wafer wird eine 0.6 µm dicke Schicht eines löslichen Polyimids (Probimide® 285, Ciba-Geigy AG) aufgetragen. Diese wird bei 300°C thermisch vernetzt. Darauf gibt man wie in Beispiel 7 beschrieben die Resistlösung. Nach dem Trocknen beträgt die Resist-Schichtdicke 0.7 µm.
Die Belichtung erfolgt wie in Beispiel 7 beschrieben, die Trockenentwicklung wird bei 110°C während 3 min. durchgeführt. Anschliessend werden die freigelegten Stellen des Polyimids im Sauerstoffplasma (40 W, 10 sccm $O_2$, $5 \cdot 10^{-3}$ mbar) während 15 min. vollständig weggeätzt, während die nichtbelichteten Stellen des Photoresistmaterials nicht angegriffen werden.

Auf diese Weise kann eine trockenentwickelte Submikronstruktur im Resist anisotrop in das darunterliegende Planarisierharz transferiert werden.

## Patentansprüche

### Patentansprüche für folgende Vertragsstaaten : CH, DE, FR, GB, IT, LI, NL, SE

1. Organometallhaltige endverkappte Polyphthalaldehyde mit der wiederkehrenden Einheit der Formel I

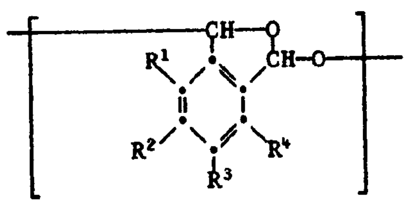

(I)

worin $R^1$, $R^2$, $R^3$ und $R^4$ unabhängig voneinander Wasserstoff, Halogen, Nitril, Nitro, Carboxyl, Hydroxyl, $C_1$-$C_4$-Alkoxy, $C_1$-$C_4$-Alkylthio oder Alkoxycarbonyl mit 1-4 C-Atomen im Alkoxyteil bedeuten und mindestens einer der Reste $R^1$, $R^2$, $R^3$ und $R^4$ eine Gruppe -$Q(R^5)_3$ oder -$Q(R^6)_3$ ist, wobei Q für Si, Sn, Ge, $CH_2$-Si oder O-Si steht, $R^5$ $C_1$-$C_{12}$-Alkyl ist und $R^6$ $C_6$-$C_{10}$-Aryl bedeutet.

2. Polyphthalaldehyde gemäss Anspruch 1 der Formel I, worin einer oder zwei der Reste $R^1$, $R^2$, $R^3$ oder $R^4$ eine Gruppe -$Q(R^5)_3$ oder -$Si(R^6)_3$ sind.

3. Polyphthalaldehyde gemäss Anspruch 2, wobei Q die Bedeutung Si, $CH_2$-Si oder O-Si hat.

4. Polyphthalaldehyde gemäss Anspruch 1 der Formel I, worin $R^3$ und/oder $R^2$ eine Gruppe -$Q(R^5)_3$ oder -$Si(R^6)_3$ bedeuten und die übrigen Substituenten Wasserstoff sind.

5. Copolymere organometallhaltige Phthalaldehyde, welche neben den Strukturelementen der Formel I gemäss Anspruch 1 bis zu 50 Mol-%, bezogen auf das gesamte Copolymer, Struktureinheiten enthalten, welche sich von copolymerisierbaren Monomeren ableiten.

6. Copolymere organometallhaltige Phthalaldehyde enthaltend das wiederkehrende Strukturelement der Formel I

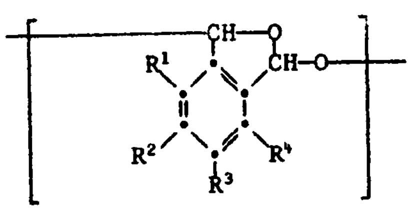

(I)

worin die Substituenten $R^1$ bis $R^4$ die im Anspruch 1 angegebene Bedeutung haben, und bis zu 50 Mol-%, bezogen auf das gesamte Copolymer, mindestens eines der Strukturelemente II, III oder IV

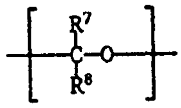

(II)

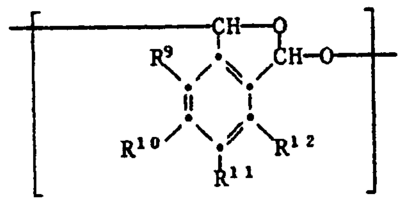

(III),

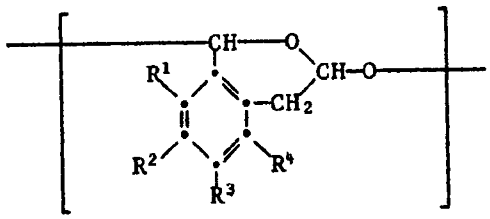

(IV)

worin $R^1$, $R^2$, $R^3$ und $R^4$ die im Anspruch 1 angegebene Bedeutung haben, und $R^7$ und $R^8$ unabhängig voneinander Wasserstoff, $C_1$-$C_4$-Alkyl, Phenyl durch eine Gruppe -Q($R^5$)$_3$ oder -Si($R^6$)$_3$ substituiertes $C_1$-$C_4$-Alkyl oder Phenyl ist und Q, $R^5$ und $R^6$ die in Anspruch 1 angegebene bedeutung haben, und $R^9$, $R^{10}$, $R^{11}$ und $R^{12}$ unabhängig voneinander Wasserstoff, Halogen, Nitril, Nitro, Carboxyl, Hydroxyl, $C_1$-$C_4$-Alkyl, $C_1$-$C_4$-Alkoxy, $C_1$-$C_4$-Alkylthio oder Alkoxycarbonyl mit 1-4 C-Atomen im Alkoxyteil bedeuten, und bedeuten, wobei Q, $R^5$ und $R^6$ die oben angegebene bedeutung haben.

7. Copolymere Phthalaldehyde gemäss Anspruch 5, welche als copolymerisierte Komponente Strukturelemente der Formel III enthalten.

8. Zusammensetzungen enthaltend ein Polyphthalaldehyd gemäss Anspruch 1 und eine unter Einwirkung von absinisches Strahlung eine Säure abspaltende Verbindung.

9. Zusammensetzungen enthaltend ein Copolymer gemäss Anspruch 5 und eine unter Einwirkung von Strahlung eine Säure abspaltende Verbindung.

10. Verwendung von Zusammensetzungen gemäss Anspruch 8 zur Herstellung von strukturierten Positiv-Bildern.

11. Verwendung von Zusammensetzungen gemäss Anspruch 9 zur Herstellung von strukturierten Positiv-Bildern.

12. Beschichtete Substrat enthaltend als Beschichtungsmittel eine Zusammensetzung gemäss Anspruch 8.

**Patentansprüche für folgenden Vertragsstaat : AT**

1. Verfahren zum Herstellen von organometallhaltigen endverkappten Polypthalaldehyden mit der wiederkehrenden Einheit der Formel I

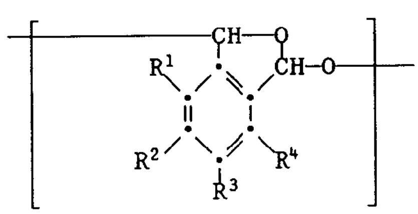

(I)

worin $R^1$, $R^2$, $R^3$ und $R^4$ unabhängig voneinander Wasserstoff, Halogen, Nitril, Nitro, Carbonyl, Hydroxyl, $C_1$-$C_4$-Alkoxy, $C_1$-$C_4$-Alkylthio oder Alkoxycarbonyl mit 1-4 C-Atomen im Alkoxyteil bedeuten und mindestens einer der Reste $R^1$, $R^2$, $R^3$ und $R^4$ eine Gruppe -Q($R^5$)$_3$ oder -Q($R^6$)$_3$ ist, wobei Q für Si, Sn, Ge, $CH_2$-Si oder O-Si steht, $R^5$ $C_1$-$C_{12}$-Alkyl ist und $R^6$ $C_6$-$C_{10}$-Aryl bedeutet, dadurch gekennzeichnet, dass man ein Phthalaldehyd der Formel V

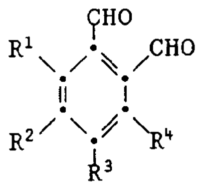

(V)

in Gegenwart eines Katalysators polymerisiert.

2. Verfahren gemäss Anspruch 1, dadurch gekennzeichnet, dass man die Polymerisation in Gegenwart mindestens eines Monomeren der Formeln II*, II* oder IV*

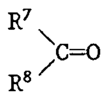 (II*), 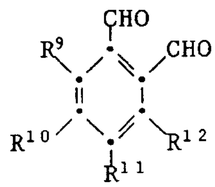 (III*),

oder

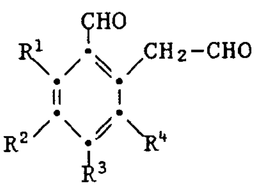 (IV*),

worin $R^1$, $R^2$, $R^3$ und $R^4$ die im Anspruch 1 angegebene Bedeutung haben, $R^7$ und $R^8$ unabhängig voneinander Wasserstoff, $C_1$-$C_4$-Alkyl, durch eine Gruppe $-Q(R^5)_3$ oder $-Si(R^6)_3$ substituiertes $C_1$-$C_4$-Alkyl oder Phenyl ist, Q, $R^5$ und $R^6$ die in Anspruch 1 angegebene Bedeutung haben und $R^9$, $R^{10}$, $R^{11}$ und $R^{12}$ unabhängig voneinander Wasserstoff, Halogen, Nitril, Nitro, Carboxyl, Hydroxyl, $C_1$-$C_4$-Alkyl, $C_1$-$C_4$-Alkoxy, $C_1$-$C_4$-Alkylthio oder Alkoxycarbonyl mit 1-4 C-Atomen im Alkoxyteil bedeuten, durchführt.

3. Zusammensetzungen enthaltend ein gemäss Anspruch 1 hergestelltes Polyphthalaldehyd und eine unter Einwirkung von Strahlung eine Säure abspaltende Verbindung.

4. Zusammensetzungen enthaltend ein gemäss Anspruch 2 hergestelltes Copolymer und eine unter Einwirkung von Strahlung eine Säure abspaltende Verbindung.

5. Verwendung von Zusammensetzungen gemäss Anspruch 3 zur Herstellung von strukturierten Positiv-Bildern.

6. Verwendung von Zusammensetzungen gemäss Anspruch 4 zur Herstellung von strukturierten Positiv-Bildern.

7. Beschichtete Substrate enthaltend als Beschichtungsmittel eine Zusammensetzung gemäss Anspruch 3.

## Claims

### Claims for the following Contracting States : CH, DE, FR, GB, IT, LI, NL, SE

1. An organometallic, end-capped polyphthalaldehyde containing the repeating unit of formula I

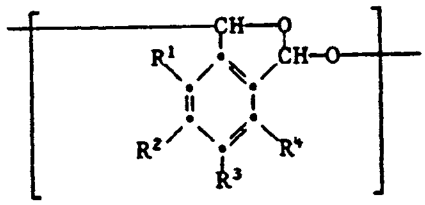

(I)

in which $R^1$, $R^2$, $R^3$ and $R^4$ are each independently of the other hydrogen, halogen, nitrile, nitro, carboxyl, hydroxyl, $C_1$-$C_4$alkoxy, $C_1$-$C_4$alkylthio or alkoxycarbonyl having 1-4 carbon atoms in the alkoxy moiety, and at least one of the radicals $R^1$, $R^2$, $R^3$ and $R^4$ is a group $-Q(R^5)_3$ or $-Q(R^6)_3$, where Q is Si, Sn, Ge, $CH_2$-Si or O-Si, $R^5$ is $C_1$-$C_{12}$alkyl and $R^6$ is $C_6$-$C_{10}$aryl.

2. A polyphthalaldehyde according to claim 1 of formula I, in which one or two of the radicals $R^1$, $R^2$, $R^3$ and $R^4$ are a group $-Q(R^5)_3$ or $-Si(R^6)_3$.

3. A polyphthalaldehyde according to claim 2, where Q is Si, $CH_2$-Si or O-Si.

4. A polyphthalaldehyde according to claim 1 of formula I, in which $R^3$ and/or $R^2$ are a group $-Q(R^5)_3$ or $-Si(R^6)_3$ and the other substituents are hydrogen.

5. A copolymer of an organometallic phthalaldehyde which, in addition to containing the structural elements of formula I according to claim 1, contains up to 50 mol %, based on the entire copolymer, of structural units which are derived from copolymerisable monomers.

6. A copolymer of an organometallic phthalaldehyde containing the repeating structural element of formula I

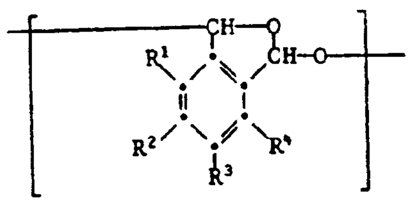

(I)

in which the substituents $R^1$ to $R^4$ are as defined in claim 1, and up to 50 mol %, based on the entire copolymer, of at least one of the structural elements II, III and IV

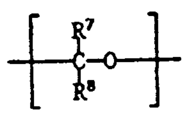

(II)

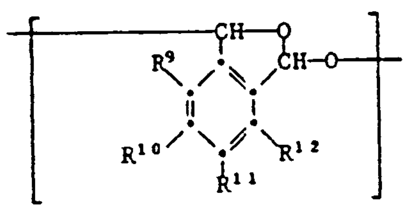

(III),

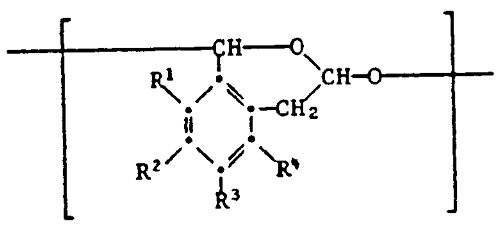

(IV)

in which $R^1$, $R^2$, $R^3$ and $R^4$ are as defined in claim 1 and $R^7$ and $R^8$ are each independently of the other hydrogen, $C_1$-$C_4$alkyl, phenyl, or $C_1$-$C_4$alkyl or phenyl each substituted by a group $-Q(R^5)_3$ or $-Si(R^6)_3$, and Q, $R^5$ and $R^6$ are as defined in claim 1 and $R^9$, $R^{10}$, $R^{11}$ and $R^{12}$ are each independently of the other hydrogen, halogen, nitrile, nitro, carboxyl, hydroxyl, $C_1$-$C_4$alkyl, $C_1$-$C_4$alkoxy, $C_1$-$C_4$alkylthio or alkoxycarbonyl having 1-4 carbon atoms in the alkoxy moiety, Q, $R^5$ and $R^6$ being as defined above.

7. A copolymer of a phthalaldehyde according to claim 5, which contains structural elements of formula III as the copolymerised component.

8. A composition comprising a polyphthalaldehyde according to claim 1 and a compound that splits off an

acid when exposed to actinic radiation.

9. A composition comprising a copolymer according to claim 5 and a compound that splits off an acid when exposed to radiation.

10. Use of a composition according to claim 8 for producing structured positive images.

11. Use of a composition according to claim 9 for producing structured positive images.

12. A coated substrate comprising a composition according to claim 8 as coating agent.

## Claims

### Claims for the following Contracting States : AT

1. A process for the preparation of an organometallic, end-capped polyphthalaldehyde containing the repeating unit of formula I

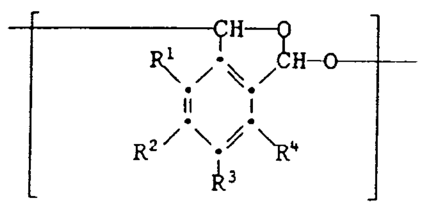

(I)

in which $R^1$, $R^2$, $R^3$ and $R^4$ are each independently of the other hydrogen, halogen, nitrile, nitro, carboxyl, hydroxyl, $C_1$-$C_4$alkoxy, $C_1$-$C_4$alkylthio or alkoxycarbonyl having 1-4 carbon atoms in the alkoxy moiety, and at least one of the radicals $R^1$, $R^2$, $R^3$ and $R^4$ is a group $-Q(R^5)_3$ or $-Q(R^6)_3$, where Q is Si, Sn, Ge, $CH_2$-Si or O-Si, $R^5$ is $C_1$-$C_{12}$alkyl and $R^6$ is $C_6$-$C_{10}$aryl, which comprises polymerising a phthalaldehyde of formula V

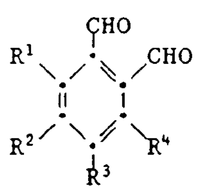

(V)

in the presence of a catalyst.

2. A process according to claim 1, which comprises carrying out the polymerisation in the presence of at least one monomer of formulae II*, III* and IV*

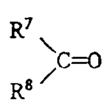

(II*),

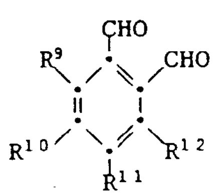

(III*),

and

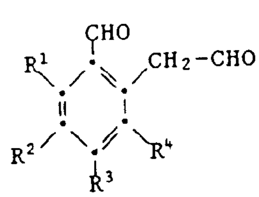

(IV*),

in which $R^1$, $R^2$, $R^3$ and $R^4$ are as defined in claim I and $R^7$ and $R^8$ are each independently of the other hydrogen, $C_1$-$C_4$alkyl, or $C_1$-$C_4$alkyl or phenyl each substituted by a group $-Q(R^5)_3$ or $-Si(R^6)_3$, and Q, $R^5$ and $R^6$ are as

defined in claim 1 and $R^9$, $R^{10}$, $R^{11}$ and $R^{12}$ are each independently of the other hydrogen, halogen, nitrile, nitro, carboxyl, hydroxyl, $C_1$-$C_4$alkyl, $C_1$-$C_4$alkoxy, $C_1$-$C_4$alkylthio or alkoxycarbonyl having 1-4 carbon atoms in the alkoxy moiety.

3. A composition comprising a polyphthalaldehyde prepared according to claim 1 and a compound that splits off an acid when exposed to radiation.

4. A composition comprising a copolymer prepared according to claim 2 and a compound that splits off an acid when exposed to radiation.

5. Use of a composition according to claim 3 for producing structured positive images.

6. Use of a composition according to claim 4 for producing structured positive images.

7. A coated substrate comprising a composition according to claim 3 as coating agent.

## Revendications

### Revendications pour les Etats contractants suivants : CH, DE, FR, GB, IT, LI, NL, SE

1. Poly-phtalaldéhydes renfermant des radicaux organométalliques et à extrémités masquées, qui comportent l'unité répétée répondant à la formule I :

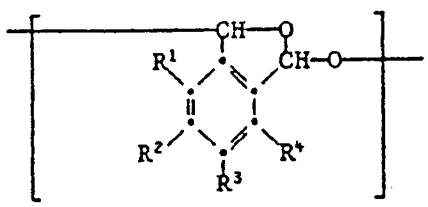

(I)

dans laquelle $R^1$, $R^2$, $R^3$ et $R^4$ représentent chacun, indépendamment les uns des autres, l'hydrogène, un halogène, un cyano, un nitro, un carboxy, un hydroxy, un alcoxy en $C_1$-$C_4$, un alkylthio en $C_1$-$C_4$ ou un alcoxycarbonyle dont la partie alcoxy contient de 1 à 4 atomes de carbone, et au moins un des symboles $R^1$, $R^2$, $R^3$ et $R^4$ représente un radical $-Q(R^5)_3$ ou un radical $-Q(R^6)_3$ dans lesquels Q représente Si, Sn, Ge, $CH_2$-Si ou O-Si, $R^5$ un alkyle en $C_1$-$C_{12}$ et $R^6$ un aryle en $C_6$-$C_{10}$.

2. Poly-phtalaldéhydes de formule I selon la revendication 1 dans lesquels un ou deux des symboles $R^1$, $R^2$, $R^3$ et $R^4$ représentent un radical $-Q\ (R^5)_3$ ou $-Si\ (R^6)_3$,

3. Poly-phtalaldéhydes selon la revendication 2 dans lesquels Q représente Si, $CH_2$-Si ou O-Si.

4. Poly-phtalaldéhydes de formule I selon la revendication 1 dans lesquels $R^3$ et/ou $R^2$ représentent un radical $-Q(R^5)_3$ ou $-Si(R^6)_3$, et les autres substituants sont chacun l'hydrogène.

5. Phtalaldéhydes copolymères à radicaux organométalliques qui, en plus des unités structurales de formule I selon la revendication 1, contiennent jusqu'à 50 % en moles, par rapport à la totalité du copolymère, d'unités structurales dérivant de monomères copolymérisables.

6. Phtalaldéhydes copolymères à radicaux organométalliques, qui contiennent l'unité structurale répétée répondant à la formule I :

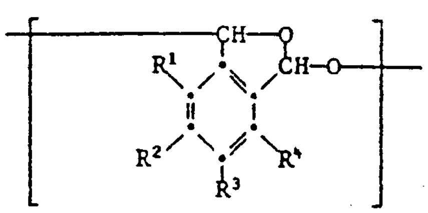

(I)

dans laquelle les symboles $R^1$ à $R^4$ ont les significations indiquées à la revendication 1, et jusqu'à 50 % en moles, par rapport à la totalité du copolymère, d'au moins une unité structurale répondant à l'une des formules II, III et IV :

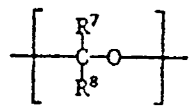 (II)

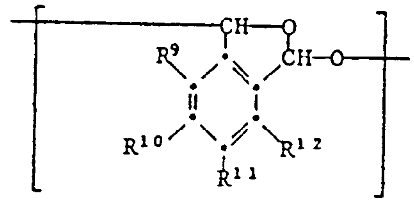 (III),

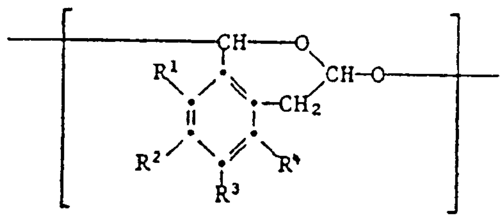 (IV)

dans lesquelles $R^1$, $R^2$, $R^3$ et $R^4$ ont les significations données à la revendication 1, $R^7$ et $R^8$ représentent chacun, indépendamment l'un de l'autre, l'hydrogène, un alkyle en $C_1$-$C_4$, un phényle, ou un radical alkyle en $C_1$-$C_4$ ou phényle porteur d'un radical $-Q(R^5)_3$ ou $-Si(R^6)_3$, Q, $R^5$ et $R^6$ ont les significations indiquées à la revendication 1, et $R^9$, $R^{10}$, $R^{11}$ et $R^{12}$ représentent chacun, indépendamment les uns des autres, l'hydrogène, un halogène, un cyano, un nitro, un carboxy, un hydroxy, un alkyle en $C_1$-$C_4$, un alcoxy en $C_1$-$C_4$, un alkylthio en $C_1$-$C_4$ ou un alcoxycarbonyle dont la partie alcoxy contient de 1 à 4 atomes de carbone,les symboles Q, $R^5$ et $R^6$ ayant les significations indiquées ci-dessus.

7. Phtalaldéhydes copolymères selon la revendication 5 qui contiennent des unités structurales de formule III comme composantes copolymérisées.

8. Compositions contenant un poly-phtalaldéhyde selon la revendication 1 et un composé libérant un acide sous l'action d'un rayonnement actinique.

9. Compositions contenant un copolymère selon la revendication 5 et un composé libérant un acide sous l'action d'un rayonnement.

10. Application de compositions selon la revendication 8 à la réalisation d'images positives structurées.

11. Application de compositions selon la revendication 9 à la réalisation d'images positives structurées.

12. Substrat revêtu comportant, comme produit de revêtement, une composition selon la revendication 8.

## Revendications

### Revendications pour l'Etat contractant suivant : AT

1. Procédé pour préparer des poly-phtalaldéhydes renfermant des radicaux organométalliques et à extrémités masquées, qui comportent l'unité répétée répondant à la formule I :

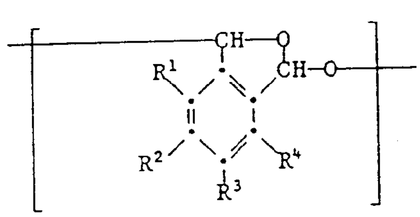 (I)

dans laquelle $R^1$, $R^2$, $R^3$ et $R^4$ représentent chacun, indépendamment les uns des autres, l'hydrogène, un halogène, un cyano, un nitro, un carboxy, un hydroxy, un alcoxy en $C_1$-$C_4$, un alkylthio en $C_1$-$C_4$ ou un alcoxycarbonyle dont la partie alcoxy contient de 1 à 4 atomes de carbone, et au moins un des symboles $R^1$, $R^2$, $R^3$ et $R^4$ représente un radical $-Q(R^5)_3$ ou un radical $-Q(R^6)_3$ dans lesquels Q représente Si, Sn, Ge, $CH_2$-Si ou O-Si, le $R^5$ un alkyle en $C_1$-$C_{12}$ et $R^6$ un aryle en $C_6$-$C_{10}$, procédé caractérisé en ce qu'on polymérise un phtalaldéhyde de formule V :

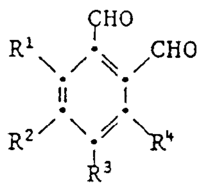

(V)

en présence d'un catalyseur.

2. Procédé selon la revendication 1 caractérisé en ce que la polymérisation est effectuée en présence d'au moins un monomère répondant à l'une des formules II*, III* et IV* ;

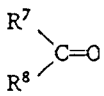

(II*),

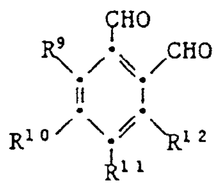

(III*),

dans lesquelles $R^1$, $R^2$, $R^3$ et $R^4$ ont les significations données à la revendication 1, $R^7$ et $R^8$ représentent chacun, indépendamment l'un de l'autre, l'hydrogène, un alkyle en $C_1$-$C_4$, ou un radical phényle ou alkyle en $C_1$-$C_4$ porteur d'un radical $-Q(R^5)_3$ ou $-Si(R^6)_3$, Q, $R^5$ et $R^6$ ont les significations indiquées à la revendication 1, et $R^9$, $R^{10}$, $R^{11}$ et $R^{12}$ représentent chacun, indépendamment les uns des autres, l'hydrogène, un halogène, un cyano, un nitro, un carboxy, un hydroxy, un alkyle en $C_1$-$C_4$, un alcoxy en $C_1$-$C_4$, un alkylthio en $C_1$-$C_4$ ou un alcoxycarbonyle dont la partie alcoxy contient de 1 à 4 atomes de carbone.

3. Compositions contenant un poly-phtalaldéhyde préparé selon la revendication 1 et un composé libérant un acide sous l'action d'un rayonnement.

4. Compositions contenant un copolymère préparé selon la revendication 2 et un composé libérant un acide sous l'action d'un rayonnement.

5. Application de compositions selon la revendication 3 à la réalisation d'images positives structurées.

6. Application de compositions selon la revendication 4 à la réalisation d'images positives structurées.

7. Substrats revêtus comportant une composition selon la revendication 3 comme produit de revêtement.